# EUROPÄISCHE PATENTSCHRIFT

(11) **EP 1 798 782 B1**
(45) Veröffentlichungstag und Bekanntmachung des Hinweises auf die Patenterteilung: **26.11.2008**
(21) Anmeldenummer: 05027249.1
(22) Anmeldetag: 13.12.2005
(51) Int. Cl.: H01L 41/083, H01L 41/053, H01L 41/047, F02M 51/06, F02M 59/46

(54) **Piezoaktuator und Verfahren zum Herstellen eines Piezostapels**
Piezoelectric actuator and manufacturing method of a piezostack
Actionneur piézo-électrique et méthode de fabrication d'un empilement piézo-électrique

(43) Veröffentlichungstag der Anmeldung: 20.06.2007
(73) Patentinhaber: Continental Automotive GmbH, 30165 Hannover (DE)
(72) Erfinder: Kronberger, Maximilian, Dr., 93053 Regensburg (DE)

(56) Entgegenhaltungen:
- EP-A- 0 545 391
- EP-A- 1 160 885
- DE-A1- 10 217 097
- DE-A1- 10 256 980
- DE-A1- 19 909 482
- DE-A1-3102004 012 03
- DE-A1-3102004 012 28

## Beschreibung

Die Erfindung betrifft einen Piezoaktuator für ein Kraftstoffeinspritzventil eines Verbrennungsmotors und ein Verfahren zum Herstellen eines Piezostapels.

Ein Piezoaktuator ist beispielsweise in der DE 102 51 225 A1 offenbart. Dieser Piezoaktuator weist ein Gehäuse, einen innerhalb des Gehäuses angeordneten Piezostapel mit Anschlussstiften, eine mit Öffnungen zum Durchtritt der Anschlussstifte versehene und auf dem Gehäuse aufgesetzte Kopfplatte und eine an der Kopfplatte aufgesetzte Kontaktbaugruppe für eine elektrische Verbindung der Anschlussstifte mit einem Steckverbinder auf. Der Piezostapel wird aus einem Piezoblock hergestellt und hat einen eckigen, z.B. quadratischen Querschnitt. Das Gehäuse eines Piezoaktuators für ein Kraftstoffeinspritzventil ist in der Regel zumindest in dem Bereich des Piezostapels zylinderförmig, z.B. als Wellrohrabschnitt ausgebildet, wodurch der durch das Gehäuse bereitgestellte Raum für den eckigen Piezostapel relativ schlecht ausgenützt wird.

Die EP 1 160 885 A2 offenbart einen fassförmigen Piezostapel mit an seiner Mantelfläche gegenüberliegenden flachen Freistellungen, an denen Kontaktierungen des Piezostapels angeordnet sind.

Die EP 0 545 391 A1 offenbart einen Piezoaktuator aus kreisrunden ferroelektrischen Scheiben, die auf beiden Seiten nahezu vollständig mit einer elektrisch leitfähigen Schicht versehen und miteinander verklebt sind. Jede elektrisch leitfähige Schicht ist mit einer Isolierung als Randzone versehen. Die Scheiben sind mit zwei kreisförmigen Ausnehmungen versehen. Elektrischen Zuleitungen zu den einzelnen leitfähigen Schichten sind als Leiterbahnen in den Ausnehmungen angeordnet.

Die DE 199 09 482 A1, die DE 102 56 980 A1 und die DE 10 2004 012 283 A1 offenbaren weitere kreiszylindrische Piezostapel.

Die DE 102 17 097 A1 offenbart ein Verfahren zum Herstellen eines tonnenförmigen Piezostapel aus einer Vielzahl von Stücken keramischer Schichten. Um die Tonneform zu erhalten, werden die Seitenflächen eines quaderförmigen Piezostapels gebogen geschliffen.

Die Aufgabe der Erfindung ist es daher, einen Piezoaktuator derart auszuführen, dass dessen Piezostapel den vom zylinderförmigen Gehäuseabschnitt bereitgestellten Raum besser ausnützt. Eine weitere Aufgabe der Erfindung ist es, ein Verfahren zum Herstellen eines Piezostapels anzugeben, das Vorraussetzungen für eine bessere Nutzung des vom zylinderförmigen Gehäuseabschnitt bereitgestellten Raums ermöglicht.

Die Aufgabe wird gelöst durch einen Piezoaktuator für ein Kraftstoffeinspritzventil, aufweisend ein Gehäuse und einen in einem zylinderförmigen Abschnitt des Gehäuses angeordneten kreiszylinderförmigen Piezostapel, an dessen Mantelfläche eine erste und eine zweite Kontaktierung angeordnet ist, der eine erste Freistellung in seiner Mantelfläche aufweist, in der die erste Kontaktierung angeordnet ist, und/oder eine zweite Freistellung in seiner Mantelfläche aufweist, in der die zweite Kontaktierung angeordnet ist, wobei der Radius des zylinderförmigen Piezostapels unter Berücksichtigung eines durch ein Bohrverfahren entstandenen Verschnitts im Wesentlichen gleich dem Radius des Kreisbogens der ersten und/oder zweiten Freistellung ist.

Allgemein entsteht ein Kreiszylinder durch Verschiebung eines Kreises parallel zu einer Geraden durch den Kreismittelpunkt des Kreises, der Achse, die nicht in der Ebene des Kreises liegt. Der Kreiszylinder wird begrenzt von zwei parallelen Kreisflächen und der Mantelfläche. Durch den erfindungsgemäßen zylinderförmigen Piezostapel ist es möglich, dass der Abstand zwischen der Mantelfläche des Piezostapels in einer Querschnittsebene im Wesentlichen überall gleichen zur Mantelfläche des zylinderförmigen Gehäuseabschnitts ist. Dadurch nützt der erfindungsgemäße kreiszylinderförmige Piezostapel den Raum des zylinderförmigen Gehäuseabschnitts besser aus als ein üblicher eckiger Piezostapel. Der erfindungsgemäße zylinderförmige Piezostapel wird z.B. hergestellt, indem er mit einem Kronenbohrer aus einem fertig geschichteten und gepressten Piezoblock geschnitten wird.

Der Piezostapel wird mit einer ersten und einer zweiten Kontaktierung kontaktiert. Diese sind insbesondere an der Mantelfläche und bevorzugt gegenüberliegend an der Mantelfläche des kreiszylinderförmigen Piezostapels angeordnet. Wenigstens einer der beiden Kontaktierungen kann entlang der gesamten Höhe des kreiszylinderförmigen Piezostapels an der Mantelfläche verlaufen. Die Kontaktierungen sind beispielsweise als Metallbeschichtung auf der Mantelfläche des Piezostapels ausgeführt. Auf dieser Metallbeschichtung kann eine zusätzliche, in Längsrichtung elastische Kontaktierung z.B. durch Bonden von Drahtbrücken aufgebracht werden, die durch den Betrieb eventuell entstehende Unterbrechungen der Metallbeschichtung überbrückt.

Um die beiden Kontaktierungen besonders Platz sparend an dem Piezostapel anzuordnen, umfasst dieser die erste Freistellung in der Mantelfläche des Piezostapels, in der die erste Kontaktierung angeordnet ist, und/oder die zweite Freistellung in der Mantelfläche des Piezostapels, in der die zweite Kontaktierung angeordnet ist. Die erste Freistellung bzw. die zweite Freistellung ist bevorzugt derart tief, dass die entsprechende Kontaktierung innerhalb des durch den Radius des kreiszylinderförmigen Piezostapels bestimmten Raums verläuft. Somit ist es möglich, den Piezostapel einschließlich der Kontaktierungen innerhalb des Kreisquerschnitts des Piezostapels unterzubringen.

Wenigstens eine Freistellung hat die Form eines Kreisbogens. Besonders einfach lässt sich der Piezostapel herstellen, da der Radius des kreiszylinderförmigen Piezostapels im Wesentlichen gleich dem Radius des Kreisbogens der ersten und/oder zweiten Freistellung ist. Wird der Piezostapel z.B. mit dem oben erwähnten Kronenbohrer aus dem fertig geschichteten und gepressten Piezoblock geschnitten, so entspricht der Radius des Piezostapels in etwa dem Radius des Kronenbohrers. Wird ein weiterer kreiszylinderförmiger Piezostapel aus dem fertig geschichteten und gepressten Piezoblock geschnitten, so ist es möglich, dass der weitere zylinderförmige Piezostapel bereits eine konkave Freistellung aufgrund des bereits aus dem Piezoblock herausgeschnittenen Piezostapels hat, indem die Ausschnittstelle im Piezoblock des weiteren Piezostapels die Ausschnittstelle des vorhergehend ausgeschnittenen Piezostapel teilweise überlappt. Dies erleichtert die Herstellung des erfindungsgemäßen Piezostapels und somit die Herstellung des erfindungsgemäßen Piezoaktuators, da der Schritt zum Herstellen zumindest einen der Freistellungen nicht durchgeführt werden muss.

Um den erfindungsgemäßen Piezoaktuator elektrisch zu isolieren, kann die Mantelfläche des kreiszylinderförmigen Piezostapels mit einer Passivierungsschicht versehen sein. Insbesondere wenn der erfindungsgemäße Piezoaktuator im Hochdruckraum nahe eines Verbrennungsmotors verwendet wird, dann ist nach einer Variante des erfindungsgemäßen Piezoaktuators dessen kreiszylinderförmiger Piezostapel mit einem Balg insbesondere gegen Kraftstoff abgedichtet. Der Balg umfasst z.B. ein Silikon. Somit wird das Volumen einer dazwischenliegenden Füllung minimiert. Dies hat den Vorteil, dass Effekte, die durch unterschiedliche Wärmeausdehnungskoeffizienten des Piezomaterials und der Füllung (Balg) entstehen, minimiert werden können. Z.B, kann beim Balg die Wandstärke vergrößert werden, da ein geringeres Ausdehnungsvolumen aufgenommen werden muss. Dies erhöht die Robustheit des erfindungsgemäßen Piezoaktuators und erleichtert dessen Fertigung.

Die Aufgabe der Erfindung wird auch gelöst durch ein Verfahren zum Herstellen eines Piezostapels, aufweisend folgende Verfahrensschritte: Ausschneiden eines kreiszylinderförmigen Piezostapels z.B. mit einem Kronenbohrer aus einem fertig geschichteten und gepressten Piezoblock, Versehen des Piezostapels mit wenigstens einer Freistellung und Anordnung einer Kontaktierung des Piezostapels im Bereich der Freistellung. Ein solch gefertigter kreiszylinderförmiger Piezostapel ist geeignet für den erfindungsgemäßen Piezoaktuator, wobei der durch das Ausschneiden erzielte Radius des zylinderförmigen Piezostapels unter Berücksichtigung des durch das Bohrverfahren entstandenen Verschnitts im Wesentlichen gleich dem Radius des Kreisbogens der ersten und/oder zweiten Freistellung wird.

Wird gemäß einer bevorzugten Ausführungsform des erfindungsgemäßen Verfahrens zusätzlich ein weiterer kreiszylinderförmiger Piezostapel aus dem fertig geschichteten und gepressten Piezoblock ausgeschnitten, so ist es möglich, dass der weitere Piezostapel bereits eine Freistellung aufgrund des bereits aus den Piezoblocks ausgeschnittenen Piezostapels aufweist. Im Bereich dieser Freistellung kann anschließend eine Kontaktierung des weiteren Piezostapels angeordnet werden.

Ausführungsbeispiele sind exemplarisch in den schematischen Zeichnungen dargestellt. Es zeigen:
- Fig. 1: einen Piezoaktuator,
- Fig. 2: einen Querschnitt durch den Piezoaktuator der Fig. 1,
- Fig. 3: einen Längsschnitt durch den Piezoaktuator der Fig. 1,
- Fig. 4: einen Piezoblock,
- Fig. 5 bis 7: einen Piezoblock für den Piezoaktuator der Fig. 1 während verschiedener Herstellungsstufen,
- Fig. 8: einen weiteren Piezostapel,
- Fig. 9 und 10: zwei Ansichten eines weiteren nicht erfindungsgemäßen Piezostapel und
- Fig. 11 und 12: zwei Ansichten eines weiteren nicht erfindungsgemäßen Piezostapel.

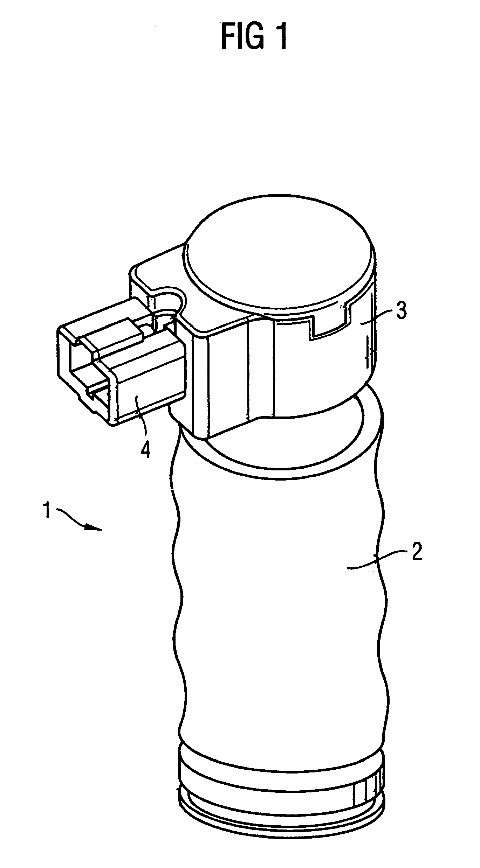

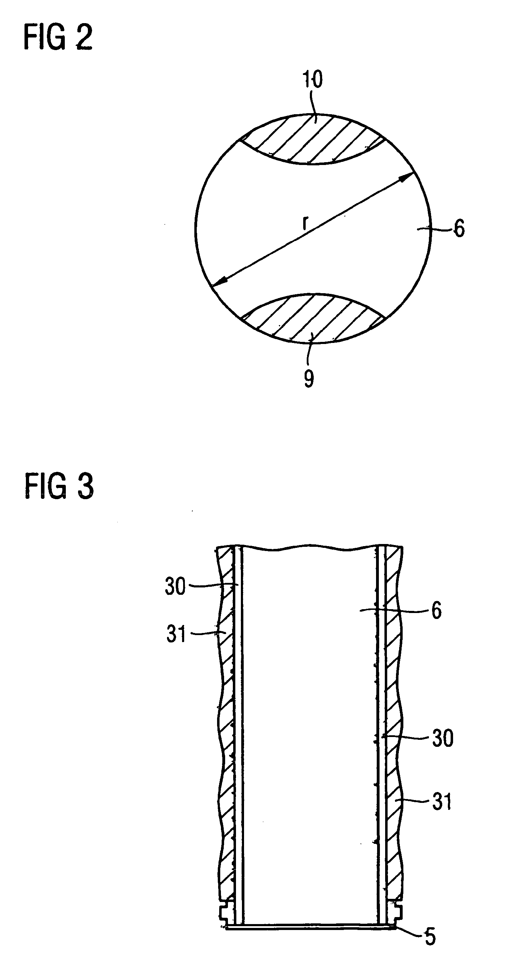

Die Fig. 1 zeigt einen Piezoaktuator 1 mit einem im Falle des vorliegenden Ausführungsbeispieles wellrohrartigen Gehäuse 2 aus Metall und einem auf dem Gehäuse 2 aufgesetzten Kunststoffgehäuse 3 mit einem Stecker 4. Das Kunststoffgehäuse 3 umgibt eine nicht näher dargestellte Kontaktbaugruppe zum Anschluss des Piezoaktuators 1 und schließt das Gehäuse 2 auf einer Seite ab. Das andere Ende des Gehäuses 2 ist mit einer in der Fig. 2 dargestellten Platte oder Membran 5 abgedichtet. Im Bereich der Membran 5 ist in an sich bekannter Weise eine Wirkverbindung zwischen einem in den Fig. 2, 3 und 5 bis 7 dargestellten und innerhalb des Gehäuses 2 angeordneten Piezostapels 6 und einem nicht dargestellten Kraftstoffeinspritzventil vorgesehen, um eine axiale Längsveränderung des Piezostapels 6 auf ein Betätigungsglied eines Einlassventils des Kraftstoffeinspritzventils zu übertragen.

Der Piezostapel 6 ist kreiszylinderförmig ausgeführt und hat eine Höhe h und einen Radius r. Ein Längsschnitt des innerhalb des Gehäuses 2 angeordneten Piezostapels 6 ist in der Fig. 2 und ein Querschnitt des innerhalb des Gehäuses 2 angeordneten Piezostapels 6 ist in der Fig. 3 gezeigt.

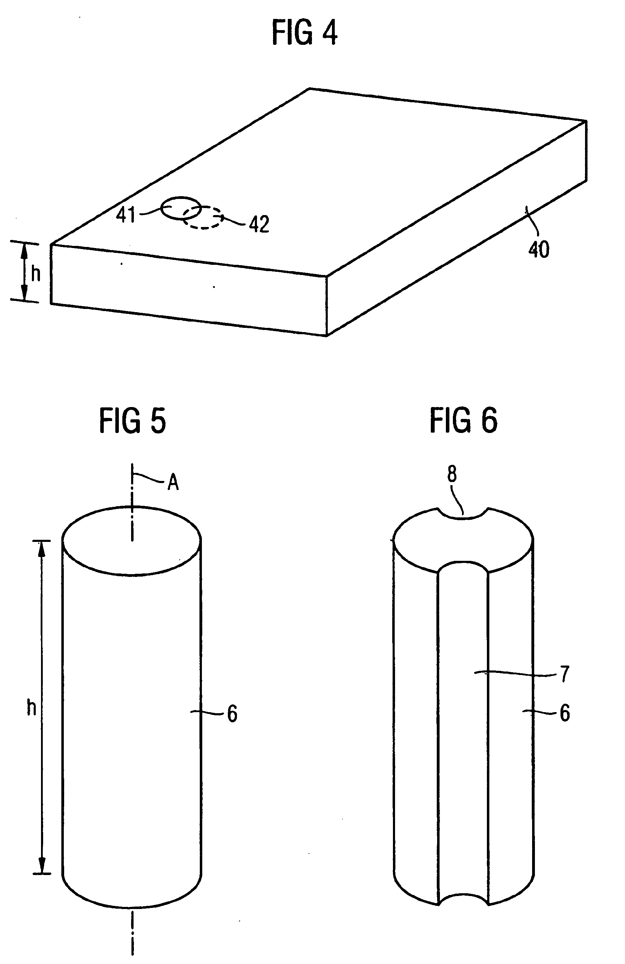

Im Falle des vorliegenden Ausführungsbeispieles wird der Piezostapel 6 aus einem in de Fig. 4 gezeigten fertig geschichteten und gepressten Piezoblock 40 der Höhe h mit einem nicht dargestellten Kronenbohrer geschnitten. Der aus dem Piezoblock 40 geschnittenen Piezostapel 6 hinterlässt ein Loch 41 im Piezostapel 40.

Bei dem Piezostapel 6 handelt es sich im Falle des vorliegenden Ausführungsbeispiels um den ersten aus dem Piezoblock 50 geschnittenen Piezostapel 6. Daher hat dieser zunächst die Form eines kompletten Kreiszylinders. Der Piezostapel 6 in diesem Fertigungsstadium ist in der Fig. 5 gezeigt.

Anschließend werden in die Mantelfläche des kreiszylinderförmigen Piezostapels 6 gegenüberliegend jeweils eine Freistellung 7, 8 geschnitten, die im Falle des vorliegenden Ausführungsbeispiels über die gesamte Höhe h und parallel zur Längsachse A des Piezostapels 6 verlaufen. Der Piezostapel 6 mit den Freistellungen 7, 8 ist in der Fig. 6 gezeigt. Im Falle des vorliegenden Ausführungsbeispiels sind die Freistellungen 7, 8 konkav in die Mantelfläche des Piezostapels 6 geschnitten und haben die Form eines Kreisbogens, dessen Radius dem Außenradius des Kronenohres entspricht, mit dem der Piezostapel 6 aus dem Piezoblock 40 geschnitten wurde. Somit ist der Radius der Kreisbögen der Freistellungen 7, 8 ähnlich groß dem Radius r des kreiszylinderförmigen Piezostapels 6.

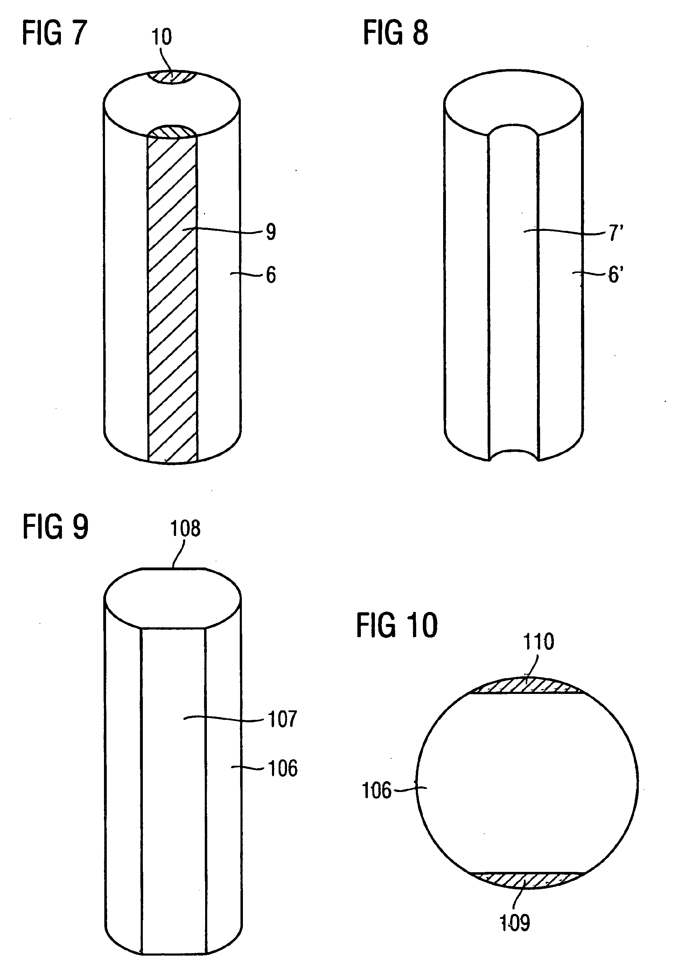

Anschließend werden die beiden Freistellungen 7, 8 jeweils mit einer Metallbeschichtung und einer nicht näher dargestellten elastischen Überbrückungskontaktierung versehen, die Kontaktierungen 9, 10 des Piezostapels 6 darstellen. Der Piezostapel 6 einschließlich der schraffiert gekennzeichneten Kontaktierungen 9, 10 ist in der Fig. 7 dargestellt. Die Kontaktierungen 9, 10 sind derart ausgeführt, dass sie innerhalb des Kreisquerschnitts, der durch die kreiszylindrische Form des Piezostapels 6 gegeben ist, untergebracht sind.

Bevor der Piezostapel 6 mit seinen Kontaktierungen 9, 10 in das Gehäuse 2 des Piezoaktuators 1 angeordnet wird, wird der Piezostapel im Falle des vorliegenden Ausführungsbeispiels noch mit einer Passivierungsschicht 30 umgeben, die den Piezostapel 6 vom Gehäuse 2 elektrisch isoliert. Außerdem wird im Falle des vorliegenden Ausführungsbeispiels der Raum zwischen dem Piezostapel 6 und der Innenwandung des Gehäuses 2 mit einem in der Fig. 3 schraffiert dargestellten Balg 31 aus Silikon gefüllt. Der Balg 31 ist insbesondere dafür vorgesehen, den Piezostapel 6 im Betrieb des Piezoaktuators 1 und in Kombination mit einem Einspritzventil eines Verbrennungsmotors gegen Kraftstoff des Verbrennungsmotors abzudichten. Somit wird der Raum zwischen der Innenwandung des Gehäuses 2 und dem Piezostapels 6 mit dieser Füllung minimiert.

Aus dem Piezoblock 40 wird nicht nur der Piezostapel 6, sondern es werden auch weitere Piezostapel, die für weitere Piezoaktuatoren, die dem Piezoaktuator 1 entsprechen, geschnitten. Die Fig. 8 zeigt ein Beispiel eines weiteren aus dem Piezoblock 40 mit dem Kronenbohrer geschnittenen Piezostapel 6' in seinem Fertigungsstadium direkt nach dem Ausschneiden. Der Piezostapel 6` ist ebenfalls kreiszylinderförmig und hat denselben Radius r und dieselbe Höhe h wie der Piezostapel 6.

Im Falle des vorliegenden Ausführungsbeispiels wird die Ausschnittstelle 42 im Piezoblock 40 für den in de Fig. 8 gezeigten Piezostapel 6' derart gewählt, dass diese das durch den ausgeschnittenen Piezostapel 6 verursachte Loch 41 im Piezoblock 40 teilweise überdeckt. Die Ausschnittsstelle 42 ist in der Fig. 4 strichliert dargestellt. Somit hat der direkt aus dem Piezoblock 40 ausgeschnittene und in der Fig. 8 gezeigte Piezostapel 6' bereits eine konkave Freistellung 7' der Form eines Kreisbogens mit einem dem Außenradius des Kronenbohrers entsprechenden Radius. Die Freistellung 7' verläuft parallel zur Längsachse des Piezostapels 6' über dessen gesamte Höhe h und ist für eine der beiden Kontaktierungen des Piezostapels 6' vorgesehen. Somit ist es nur noch nötig, eine gegenüber der Freistellung 7' liegende zweite Freistellung in die Mantelfläche des Piezostapel 6' zu schneiden. Die beiden Freistellungen werden danach jeweils metallbeschichtet, um zwei Kontaktierungen für den Piezostapel 6' zu erhalten.

Die voranstehend beschriebenen Piezostapel 6, 6' haben konkave Freistellungen 7, 7', 8 in ihren Mantelflächen für die Kontaktierungen 9, 10. Die Figuren 9 und 10 zeigen einen weiteren Piezostapel 106, der keine konkaven Freistellungen 7, 7', 8 hat.

Im Falle des vorliegenden Ausführungsbeispiels wurde der Piezostapel 106 ebenfalls mit einem Kronenbohrer aus einem fertig geschichteten und gepressten Piezoblock vergleichbar dem Piezoblock 50 geschnitten. Der Piezostapel 106 hat direkt nach dem Herausschneiden aus dem Piezoblock die Form des in der Fig. 5 gezeigten Piezostapels 6. Anschließend wird der Piezostapel 106 jedoch nicht mit zwei konkaven Freistellungen 7, 8, sondern mit zwei flachen Freistellungen 107, 108 versehen, wie dies in den Figuren 8 und 9 veranschaulicht ist. Die Freistellungen 107, 108 verlaufen im Falle des vorliegenden Ausführungsbeispiels über die gesamte Länge der Mantelfläche des Piezostapels 106 parallel zu dessen Längsachse. Anschließend werden die Freistellungen 107, 108 mit einem Metall beschichtet, wodurch in der Fig. 10 schraffiert dargestellte Kontaktierungen 109, 110 des Piezostapels 106 entstehen.

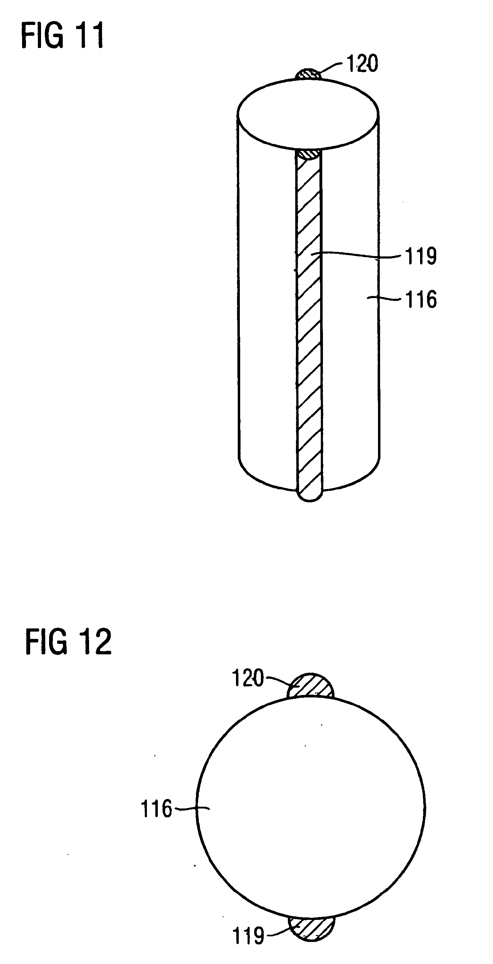

Die Figuren 11 und 12 zeigen ein weiteres Beispiel eines Piezostapel 116 mit zwei Kontaktierungen 119, 120. Der Piezostapel 116 wurde ebenfalls aus einem Piezoblock geschnitten und ist kreiszylinderförmig. Der Piezostapel 116 hat direkt nach dem Herausschneiden aus dem Piezoblock die Form des in der Fig. 5 gezeigten Piezostapels 6. Anschließend wird der Piezostapel 116 jedoch nicht mit Freistellungen versehen, sondern es werden parallel zu dessen Längsachse zwei streifenförmige Metallbeschichtungen an dessen Mantelfläche aufgetragen, die die in den Figuren 11 und 12 schraffiert dargestellten Kontaktierungen 119, 120 ergeben.

Obwohl die vorliegende Erfindung anhand eines bevorzugten Ausführungsbeispieles beschrieben wurde, ist die vorliegende Erfindung nicht auf diese beschränkt, sondern auf vielfältige Weise modifizierbar.

So wird beispielsweise der durch das Bohrverfahren, bevorzugt durch Kronbohren, entstehende Span mit Hilfe von Flüssigkeit oder Gas entfernt, wodurch eine hohe Bohrgeschwindigkeit erzielbar ist.

Weiterhin wird vorzugsweise der durch das Ausschneiden des Piezostapels erzielte Radius (r) des zylinderförmigen Piezostapels 6, 6' unter Berücksichtigung des durch das Bohrverfahren entstandenen Verschnitts im Wesentlichen gleich dem Radius des Kreisbogens der ersten und/oder zweiten Freistellung 7, 7', 8.

Weiterhin wird vorzugsweise jeweils mindestens ein Anschlussdraht mit der ersten bzw. zweiten Kontaktierung 9,109, 10,110 elektrisch leitend verbunden, wobei der mindestens eine Anschlussdraht im Wesentlichen innerhalb der ersten bzw. zweiten Freistellung 7, 7', 8, 107, 108 109 zur jeweiligen Stirnfläche des Piezoaktuators geführt ist. Dadurch ist ein Platz sparender, vorzugsweise im Querschnitt kreisförmiger Aufbau des Piezoaktors möglich.

## Patentansprüche

1. Piezoaktuator für ein Kraftstoffeinspritzventil, aufweisend ein Gehäuse (2) und einen in einem zylinderförmigen Abschnitt des Gehäuses (2) angeordneten kreiszylinderförmigen Piezostapel (6, 6'), an dessen Mantelfläche eine erste und eine zweite Kontaktierung (9, 10) angeordnet ist, der eine erste Freistellung (7, 7') in seiner Mantelfläche aufweist, in der die erste Kontaktierung (9) angeordnet ist, und/oder eine zweite Freistellung (8) in seiner Mantelfläche aufweist, in der die zweite Kontaktierung (10) angeordnet ist,
**dadurch gekennzeichnet,**
**dass** die erste Freistellung (7, 7') und/oder die zweite Freistellung (8) in Form eines Kreisbogens ausgebildet sind und der Radius (r) des zylinderförmigen Piezostapels (6, 6') unter Berücksichtigung eines durch ein Bohrverfahren entstandenen Verschnitts im Wesentlichen gleich dem Radius des Kreisbogens der ersten und/oder zweiten Freistellung (7, 7', 8) ist.

2. Piezoaktuator nach Anspruch 1, bei dem die beiden Kontaktierungen (9, 10) gegenüberliegend an der Mantelfläche des zylinderförmigen Piezostapels (6, 6') angeordnet sind und/oder wenigstens einer der beiden Kontaktierungen (9, 10) entlang der gesamten Höhe des zylinderförmigen Piezostapels verläuft.

3. Piezoaktuator nach Anspruch 1 oder 2, dessen erste Freistellung (7, 7') derart tief ist, dass die erste Kontaktierung (9) innerhalb des durch den Radius (r) des zylinderförmigen Piezostapels (6, 6') bestimmten Raums verläuft und/oder dessen zweite Freistellung (8) derart tief ist, dass die zweite Kontaktierung (10, 110) innerhalb des durch den Radius (r) des zylinderförmigen Piezostapels (6, 6') bestimmten Raums verläuft.

4. Piezoaktuator nach einem der Ansprüche 1 bis 3, bei dem die Mantelfläche des zylinderförmigen Piezostapels (6, 6') mit einer Passivierungsschicht (30) versehen ist und/oder dessen zylinderförmiger Piezostapel (6, 6') mit einem Balg (31) abgedichtet ist.

5. Piezoaktuator nach einem der Ansprüche 1 bis 4, bei dem jeweils mindestens ein Anschlussdraht mit der ersten bzw. der zweiten Kontaktierung (9, 10) elektrisch leitend verbunden ist, wobei der mindestens eine Anschlussdraht im Wesentlichen innerhalb der ersten bzw. zweiten Freistellung (7, 7', 8) zur jeweiligen Stirnfläche des Piezoaktuators geführt ist.

6. Verfahren zum Herstellen eines Piezostapels, aufweisend folgende Verfahrensschritte:
- Ausschneiden eines kreiszylinderförmigen Piezostapels (6, 6', 106) aus einem fertig geschichteten und gepressten Piezoblock (40),
- Versehen des Piezostapels (6, 6', 106) mit wenigstens einer ersten Freistellung (7, 8, 107, 108) und
- Anordnung einer Kontaktierung (9, 10, 109, 110) des Piezostapels (6, 6', 106) im Bereich der Freistellung (7, 7', 8, 107, 108),
**dadurch gekennzeichnet,**
**dass** der durch das Ausschneiden erzielte Radius (r) des zylinderförmigen Piezostapels (6, 6') unter Berücksichtigung des durch das Bohrverfahren entstandenen Verschnitts im Wesentlichen gleich dem Radius des Kreisbogens der ersten und/oder einer zweiten Freistellung (7, 7', 8) wird.

7. Verfahren nach Anspruch 6, aufweisend folgende zusätzliche Verfahrensschritte:
- Ausschneiden eines weiteren kreiszylinderförmigen Piezostapels (6') aus dem fertig geschichteten und gepressten Piezoblock (40), aus dem bereits ein Piezostapel (6) ausgeschnitten wurde, derart, dass der weitere Piezostapel (6') eine Freistellung (7') aufgrund des bereits herausgeschnittenen Piezostapels (6) aufweist, und
- Anordnung einer Kontaktierung (9) des weiteren Piezostapels (6') im Bereich der Freistellung (7').

8. Verfahren nach Anspruch 6 oder 7, bei dem der kreiszylinderförmige Piezostapel (6, 6') mit einem Kronenbohrer aus dem fertig geschichteten und gepressten Piezoblock (40) herausgeschnitten wird.

9. Verfahren nach Anspruch 8, bei dem der beim Kronbohren entstehende Span mit Hilfe von Flüssigkeit oder Gas entfernt wird.

## Claims

1. Piezo actuator for a fuel injection valve, having a housing (2) and a circular-cylindrical piezo stack (6, 6') arranged in a cylindrical section of the housing (2), on the lateral surface of which piezo stack (6, 6') a first and second contacting means (9, 10) are arranged, having a first recess (7, 7') in its lateral surface, in which the first contacting means (9) is arranged, and/or a second recess (8) in its lateral surface, in which the second contacting means (10) is arranged,
**characterised in that**
the first recess (7, 7') and/or the second recess (8) is configured in the form of a circular arc and the radius (r) of the cylindrical piezo stack (6, 6') is essentially identical to the radius of the circular arch of the first and/or second recess (7, 7', 8), taking into account an offcut resulting due to a drilling method.

2. Piezo actuator according to claim 1, wherein the two contacting means (9, 10) are arranged opposite each other on the lateral surface of the cylindrical piezo stack (6, 6') and/or at least one of the two contacting means (9, 10) runs along the entire height of the cylindrical piezo stack.

3. Piezo actuator according to claim 1 or 2, whose first recess (7, 7') is so deep that the first contacting means (9) runs within the space defined by the radius (r) of the cylindrical piezo stack (6, 6') and/or its second recess (8) is so deep that the second contacting means (10, 110) runs within the space defined by the radius (r) of the cylindrical piezo stack (6, 6').

4. Piezo actuator according to one of claims 1 to 3, wherein the lateral surface of the cylindrical piezo stack (6, 6') is provided with a passivation layer (30) and/or its cylindrical piezo stack (6, 6') is sealed with a bellows (31).

5. Piezo actuator according to one of claims 1 to 4, wherein at least one connecting wire is connected respectively in an electrically conducting manner to the first and/or second contacting means (9, 10), the at least one connecting wire being guided essentially within the first and/or second recess (7, 7', 8) to the respective end face of the piezo actuator.

6. Method for producing a piezo stack, having the following method steps:
- cutting a circular-cylindrical piezo stack (6, 6', 106) out of a fully stacked and pressed piezo block (40),
- providing the piezo stack (6, 6', 106) with at least a first recess (7, 8, 107, 108) and
- arranging a contacting means (9, 10, 109, 110) of the piezo stack (6, 6', 106) in the region of the recess (7, 7', 8, 107, 108),
**characterised in that**
the radius (2) of the cylindrical piezo stack (6, 6') produced by the cutting out operation is essentially identical to the radius of the circular arc of the first and/or a second recess (7, 7', 8) taking into account the offcut resulting due to the drilling method.

7. Method according to claim 6, having the following additional method steps:
- cutting a further circular-cylindrical piezo stack (6') out of the fully stacked and pressed piezo block (40), out of which a piezo stack (6) has already been cut, in such a manner that the further piezo stack (6') has a recess (7') due to the piezo stack (6) that has already been cut out and
- arranging a contacting means (9) of the further piezo stack (6') in the region of the recess (7').

8. Method according to claim 6 or 7, wherein the circular-cylindrical piezo stack (6, 6') is cut out from the fully stacked and pressed piezo block (40) using a core drill.

9. Method according to claim 8, wherein the shaving resulting from crown drilling is removed with the aid of fluid or gas.

## Revendications

1. Actionneur piézo-électrique pour un injecteur de carburant, présentant un boîtier (2) et un empilement piézo-électrique (6, 6') cylindrique à base circulaire, disposé dans un segment cylindrique du boîtier (2), contre la surface périphérique duquel sont disposés un premier et un second élément de mise en contact (9, 10), et qui présente un premier évidement (7, 7') ménagé dans sa surface périphérique, dans lequel le premier élément de mise en contact (9) est disposé et/ou un second évidement (8) ménagé dans sa surface latérale, dans lequel le second élément de mise en contact (10) est disposé,
**caractérisé**
**en ce que** le premier évidement (7, 7') et/ou le second évidement (8) sont conformés en forme d'arc de cercle et, si l'on prend en compte un enlèvement de matière résultant d'une opération de perçage, le rayon (r) de l'empilement piézo-électrique cylindrique (6, 6') est pratiquement égal au rayon de l'arc de cercle du premier et/ou du second évidement (7, 7', 8).

2. Actionneur piézo-électrique selon la revendication 1, dans lequel les deux éléments de mise en contact (9, 10) sont disposés l'un à l'opposé de l'autre sur la surface périphérique de l'empilement piézo-électriques cylindrique (6, 6') et/ou au moins un des deux éléments de mise en contact (9, 10) s'étend sur toute la hauteur de l'empilement piézo-électrique cylindrique.

3. Actionneur piézo-électrique selon la revendication 1 ou 2, dont le premier évidement (7, 7') est d'une profondeur telle que le premier élément de mise en contact (9) s'étende à l'intérieur de l'espace défini par le rayon (r) de l'empilement piézo-électriques cylindrique (6,6') et/ou dont le second évidement (8) est d'une profondeur telle que le second élément de mise en contact (10, 110) s'étende à l'intérieur de l'espace défini par le rayon (r) de l'empilement piézo-électrique cylindrique (6, 6').

4. Actionneur piézo-électrique selon une des revendications 1 à 3, dans lequel la surface périphérique de l'empilement piézo-électrique cylindrique (6 ,6') est munie d'une couche de passivation (30) et/ou son empilement piézo-électrique cylindrique (6, 6') est rendu étanche par un soufflet (31).

5. Actionneur piézo-électrique selon une des revendications 1 à 4, dans lequel, à chaque fois au moins un fil de connexion est relié par conduction électrique au premier ou au second élément de mise en contact (9, 10) respectivement, l'au moins un fil de connexion étant à chaque fois enfilé essentiellement à l'intérieur du premier ou du deuxième évidement (7, 7', 8) jusqu'à la surface frontale correspondante de l'actionneur piézo-électrique.

6. Procédé de fabrication d'un empilement piézo-électrique, présentant les étapes de procédé suivantes :
-- découper un empilement piézo-électrique cylindrique à base circulaire (6, 6', 106) dans un bloc piézo-électrique stratifié et pressé (40),
-- munir l'empilement piézo-électrique (6, 6', 106) d'au moins un premier évidement (7, 8, 107, 108) et
-- disposer un élément de mise en contact (9, 10, 109, 110) de l'empilement piézo-électrique (6, 6', 106) dans la région de l'évidement (7, 7', 8, 107, 108),
**caractérisé**
**en ce que,** si l'on prend en compte l'enlèvement de matière résultant de l'opération de perçage, le rayon (r) de l'empilement piézo-électrique cylindrique (6, 6') obtenu par le découpage devient essentiellement égal au rayon de l'arc de cercle d'un premier et/ou d'un second évidement (7, 7', 8).

7. Procédé selon la revendication 6, présentant les étapes de procédé supplémentaires suivantes :
- découper un nouvel empilement piézo-électrique cylindrique à base circulaire (6') dans le bloc pièzo-électrique (40) stratifié et pressé dans lequel un empilement piézo-électrique (6) a déjà été découpé, de telle manière que le nouvel empilement piézo-électrique (6') présente un évidement (7') résultant de l'empilement piézo-électrique (6) qui a déjà été découpé, et
- disposer un élément de mise en contact (9) de l'autre empilement piézo-électrique (6') dans la région de l'évidement (7').

8. Procédé selon la revendication 6 ou 7, dans lequel l'empilement piézo-électrique (6, 6') est découpé dans le bloc piézo-électrique (40) stratifié et pressé à l'aide d'un outil de perçage à couronne.

9. Procédé selon la revendication 8, dans lequel le copeau produit dans le perçage à l'outil à couronne est évacué à l'aide de liquide ou de gaz.
